# EUROPEAN PATENT APPLICATION

(11) **EP 3 392 403 A1**
(43) Date of publication of application: **24.10.2018**
(21) Application number: 16874612.1
(22) Date of filing: 28.09.2016
(51) Int. Cl.: D06P 1/673, C23C 14/22

(54) **WATERLESS STAINING TECHNIQUE FOR TEXTILE**

(30) Priority: 17.12.2015 CN 201510963484
(71) Applicant: Aqua Well Technology Company Limited, Lai Chi Kok Kln, Hong Kong (CN)
(72) Inventor: MIAO, Dagang, Qingdao Shandong 266011 (CN); JIANG, Shouxiang, Kowloon Hong Kong (CN)
(74) Representative: Jacobi, Markus Alexander
(86) International application number: PCT/CN2016/100499
(87) International publication number: WO 2017/101552

(57) **Abstract**

Anhydrous dyeing method for textile, including the steps of: using a pure dye as a plating material and a textile fabric as a substrate, and depositing the dye onto a surface of the textile fabric by using a physical vapor deposition technique. The color of plated textile fabric is fixed through steaming, heat setting or other post-processing methods. The invention achieves the purpose of dyeing textile fabric by depositing dye onto the surface of the textile fabric uniformly and densely using a physical vapor deposition technology, and fixing the color in a finishing step. The process is simple and convenient, produces no waste water discharge, has a high utilization rate of dye, and is operable and feasible for mass production.

## Description

### Technical field of the inventon

The present invention relates to the fields of textile dyeing and physical vapor deposition, and more particularly to a water-free dyeing method of textile.

### Background of the invention

Traditional dyeing technology of textile uses water as a medium, through the effect of heating and additives to bond dye to textile, so as to achieve the purpose of dyeing textile. The dye on the textile and the dye in the medium water maintain a dynamic balance, and after dyeing, a large amount of dye remains in the dyeing bathwater(raffinate). A variety of additives added during dyeing also partially remains in the dyeing raffinate. Because current wastewater processing technology is of high costs and furthermore it cannot fully solve the pollution problem caused by dyeing wastewater, the discharge of dyeing wastewater remains a critical and difficult problem in the effort of establishing energy-saving and pollution-free production processes in the textile industry .

Water-free fabric dyeing is a current research subject attracting a lot of attention, there are known anhydrous dyeing technology such as supercritical carbon dioxide dyeing and vacuum dye sublimation dyeing and the like. Supercritical carbon dioxide dyeing has encountered many problems in the aspects of equipment cleaning, dyeing uniformity, equipment safety, equipment investment cost, thus it has difficulty in achieving wide-spread adoption. Vacuum dye sublimation dyeing also has problems in that there are only a few available sublimation dyes, difficulties in sublimation speed control, serious equipment pollution, high requirement of dyeing equipment, which thus greatly limit its adoption and application in the textile industry. So currently a better technology is required to solve the aforesaid problems in the field of pollution-free dyeing of textile fabrics.

### Description of the invention

In view of the existing technical problems in the prior art, the present invention proposes the use of physical vapor deposition technology to carry out anhydrous dyeing of textile and expand its applications in the textile industry. Physical vapor deposition technology is a technique to form a thin film of plating materials, and then segregate the atoms or molecules of the plating material from the surface of the film and plate to the surface of the object via a physical means. Physical vapor deposition technology is simple in terms of technical processing process, improves environment friendliness, reduces pollution, requires less supplies, forms uniform and dense film, and provides a strong bonding with the substrate. Although physical vapor deposition technology has been widely used in aerospace, electronics, optics, machinery, construction, light industry, metallurgy, and new materials, it is hard to imagine - no one has so far thought about it - that the physical vapor deposition phenomenon can be used for dyeing textile. However, the present invention has experimentally demonstrated that physical vapor deposition can deposit solid dyes onto textile fabric to achieve the purpose and requirements of water-free dyeing for the textile industry.

The solution of the present invention for solving the technical problem is:
An anhydrous dyeing method of textile, comprises the steps of: using the textile fabric as a substrate and a pure dye as a plating material, depositing said dye onto a surface of said textile fabric using a physical vapor deposition technique. The color of plated textile fabric is fixed through steaming, heat setting and other post-processing methods.

According to the present invention, the anhydrous dyeing method requires the raw materials, when plating dye by the physical vapor deposition technique, be treated by the following steps:
(1) dye preparation: put a pure dye in the form of bulk, granule or powder into the oven to dry and remove extra moisture. The dye may be selected from natural dyes or synthetic dyes, typically in the form of powder, granule or lump.
(2) fabric preparation: use conventional pre-dyeing processing process, such as desizing, bleaching, oil-removing, etc, to pre-treat the textile to be dyed. The textile fabric may be made of synthetic fibers such as polyester, acetate, polyamide, polypropylene, polyvinyl chloride, acrylic, etc, or natural fibers such as cotton, linen, silk, viscose fibers, or blended fibers of the above-mentioned fibers.
(3) depositing said pure dye onto the surface of said textile fabric using physical vapor deposition techniques, the specific operation of which will be described in detail in the following embodiment.

The present invention has the advantages that the purpose of dyeing textile is achieved by depositing dye onto the surface of the textile fabric uniformly and densely using the physical vapor deposition technology, and fixing the color in a finishing step. The process is simple and convenient, and the entire production process produces no waste water discharge, has a high utilization rate of dye, and highly operable and feasible for mass production.

### Description of the drawings

The invenion will now be further described with reference to the accompanying drawings and the embodiment. In the drawings:

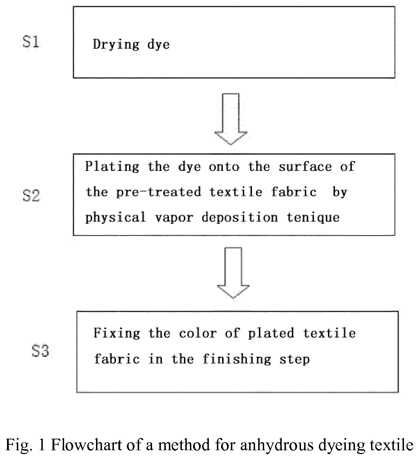

Figure 1 is a flowchart of anhydrous dyeing method of textile according to a preferred embodiment of the present invention.

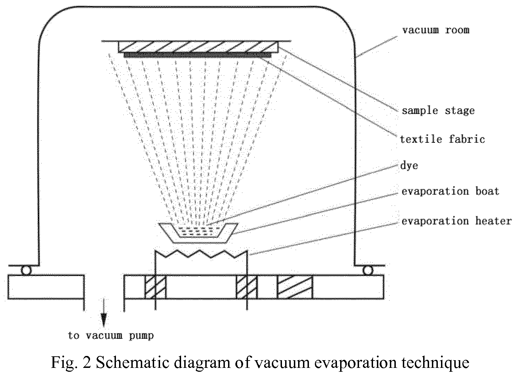

Figure 2 is a schematic diagram of the dyeing process using vacuum evaporation plating technology.

### Embodiments

The specific process of anhydrous dyeing method with a disperse dye for a polyester fabric is described as follows:
(1) Preparation of disperse dye plating material:
   The pure disperse dye (manufactured by Jiangsu Yabang: disperse red FB) in powder form was placed in a constant temperature oven (BINDER FD 53 300C), and dried at 50 °C for 20 minutes to remove extra moisture from the dye.
(2) Pre-treating textile:
   Use a conventional pre-dyeing process with steps, such as desizing, bleaching, oil-removing, etc., to pre-treat the textile to be dyed. The steps are routine operation techniques in the field, and the requirements of the pre-treatment are also usual and need not be described here.
(3) Plating of polyester fabric:
   select an oil-removed woven white fabric (100% PET, DTY, 50D/72F, 100g/m²) at a size of 15cm×15cm, place the dried disperse dye into a crucible within a high vacuum resistance evaporative plating machine (Beijing Ticono Technology Co., Ltd., ZHD-300M2). Turn on the plating machine, vacuum to 1.0 × 10⁻² Pa, adjust the resistance evaporative current to about 42A, till the current is stable. Open the baffle of evaporative crucible for starting dye plating. Control the thickness of the dye plating at around 200nm. When finishing, close the baffle of evaporator crucible, then turn off the plating machine and take out the plated polyester fabric.
(4) fixing of plated polyester fabric:
   The polyester dyed fabric prepared in step (3) was subjected to fixing in an oven (BINDER FD 53 300C). Fixation parameters: 180 °C, 3 minutes.

The color penetration effect of polyester fabric dyed by this method is ordinary by industry standards, and the color shows obvious differences on front and back sides. To reduce the color difference between the front and back sides, step (3) may be repeated once on the back side of the polyester fabric. The color depth of the polyester fabric depends on the thickness of the plated dye, and the thickness of the plated dye can be adjusted according to specific needs.

Based on testings, the polyester color cloth dyed in the above described embodiment has shown improved color fastness, and satisfies general requirements for the textile fabric used in the commerce. Thus, the present invention has realized the anhydrous dyeing process for textile fabrics.

It is to be understood that the specific embodiment of the invention described above is an example and the invention is not intended to be limited by the disclosure. It will be apparent to those skilled in the art that the present disclosure may be modified or varied in accordance with the above-mentioned examples, for example, corresponding adjustments and variations can be made to fabrics of various materials and different production scales. All such modifications and variations are intended to be within the scope of the appended claims of present disclosure.

## Claims

1. An anhydrous dyeing method for textile, comprising the steps of: (a) suspending substantially uniformly dried particles of a dye in a closed space with a predetermined degree of vacuum at a predetermined temperature; (b) passing a fabric to be dyed through the closed space to allow the dried dye particles adhere directly from a suspension state in the air to the surface of the fabric to achieve a dyeing effect, wherein the enclosed space does not contain supercritical carbon dioxide.

2. The anhydrous dyeing method according to claim 1, wherein the dried particles are of a natural dye or a synthetic dye.

3. The anhydrous dyeing method according to claim 1, wherein the dye is in the form of powder, granule or lump before being suspended in the air.

4. The anhydrous dyeing method according to claim 1, wherein the fabric is a fabric of a synthetic fiber selected from polyester, acetate, polyamide, polypropylene, polyvinyl chloride, acrylic, or a fabric of a natural fiber selected from cotton, linen, silk, viscose fibers, or a fabric of a blended fiber from said synthetic fibers and said natural fibers.

5. The anhydrous dyeing method according to claim 1, wherein said dye is suspended by a physical vapor deposition technique selected from a group consisting of vacuum deposition, sputter plating, arc plasma plating, ion plating, and molecular beam epitaxy.
